Europäisches Patentamt

European Patent Office

Office européen des brevets

(11) Publication number: **0 216 474 B1**

## EUROPEAN PATENT SPECIFICATION

(45) Date of publication of patent specification: **23.12.92**

(21) Application number: **86306031.5**

(22) Date of filing: **05.08.86**

(51) Int. Cl.⁵: **G01N 27/00**, G01F 23/24, G01F 23/26, G01R 27/22, G01R 27/26

(54) **Probe for measuring and/or for exercising a control in dependence upon the value of a characteristic of a material, and method of using said probe.**

(30) Priority: **21.08.85 GB 8520980**

(43) Date of publication of application:
**01.04.87 Bulletin 87/14**

(45) Publication of the grant of the patent:
**23.12.92 Bulletin 92/52**

(84) Designated Contracting States:
**DE GB IT**

(56) References cited:
**GB-A- 717 127**

**IEEE TRANSACTIONS ON GEOSCIENCE ELECTRONICS, vol. GE-16, no. 2, April 1978, pages 112-118, IEEE, New York, US; D. WOB-SCHALL: "A frequency shift dielectric soil moisture sensor"**

**ZEITSCHRIFT FÜR INSTRUMENTENKUNDE, vol. 72, no. 10, October 1964, pages 281-287, Braunschweig, DE; A. OTT: "Messsonde zur Bestimmung der relativen Dielektrizitätskonstanten flüssiger und fester Stoffe"**

Idem

(73) Proprietor: **AGAR CORPORATION LTD. Anderson Square Building P.O. Box 866 Grand Cayman, British West Indies(KY)**

(72) Inventor: **Agar, Joram 18 Islands Club P.O. Box 1764 Grand Cayman Cayman Islands(KY)**

(74) Representative: **Haigh, Charles Roy et al J.A. KEMP & CO. 14 South Square Gray's Inn London WC1R 5LX(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

This invention concerns a probe for measuring, and/or for exercising a control in dependence upon the value of, an electrical, magnetic or other characteristic of fluid or solid material or materials, and also concerns a method of using said probe. The characteristic may, for example, be the electrical conductivity, dielectric constant or magnetic permeability (or some combination of these particular parameters) of a gaseous liquid or solid material or of a mixture, emulsion or slurry of said materials. The characteristic may also be that of one or more of a plurality of materials which are disposed in abutting layers which meet at one or more interfaces. Thus the probe of the present invention may, for example, be used to determine the position of an interface between the oil and water of a layer of oil floating on a layer of water. Moreover, since the dielectric and resistive properties of a material are affected by the amount of water in the material, the probe of the present invention may be used to measure the water content of a material by measuring its dielectric or resistive properties after having measured those of calibrated samples.

The detection of such an interface has previously been effected by one of two methods. In the first of these methods, use has been made of a probe in which an electrode protrudes from and is insulated from a probe member, the probe being introduces into the liquid in a vessel which contains, for example, a layer of oil floating on a layer of water. Electrical energy is supplied to the probe member and to the electrode so that an electrical field is generated therebetween, the said field extending through the said liquid. The said electrical energy is affected by the electrical characteristics, e.g. the electrical impedance, of the particular liquid through which the said field extends. A substantial change in said characteristic occurs at said interface and the position of the latter can therefore be determined by moving the probe in the vessel to a position in which a change in the said characteristic is detected, provided, of course, that each of the materials at the interface has its own specific characteristics. However, in this particular method, the position of the interface cannot be very accurately determined because it is affected by the quantity of liquid through which the electrical field passes and is therefore affected by the shape and size of the vessel.

In the second of the said methods, the oil/water mixture is passed to a narrow pipe within which the probe is mounted, the electrode being made long in relation to the diameter of said pipe so that the electrical field is mostly radial and occupies the total gap between the electrode and the pipe. In this case, the volume of liquid through which the field passes is constant and consequently the position of the interface (and/or the water content of the mixture) can be accurately determined. However, it is impracticable to employ this second method to determine an interface between a quantity of an oil/water mixture (or other fluid) trapped in a vessel since differential pressure needs to be established to make the fluid trapped in the gap between the electrode and the pipe flow out of the latter.

In British Patent Specification No. 1,419,235 there is disclosed a probe for measuring a characteristic of fluid or solid material or materials, said probe comprising an elongated, electrically conductive, probe member which is insulated from and which carries at one end thereof electrode means, the probe member being spaced from the nearest part of the said electrode means by a gap; electrical means which are arranged in operation to produce an electrical field between the probe member and the said electrode means; and signal-producing means responsive to the output of the electrical means, for producing a signal functionally related to the value of said characteristic.

In the probe of British Patent Specification No. 1,419,235, however, the electrode means is constituted by a cylindrical electrode which is closed at its distal end, the axial length of the electrode being much greater than its diameter. In such an arrangement although there is a very small axially extending fringe field between the electrode and the probe member, most of the field generated by the electrode extends radially of the latter, so that the horizontal resolution of the probe of this citation is impaired.

"A Frequency Shift Dielectric Soil Moisture Sensor" by D. Wobschall, IEEE Transactions on Geoscience Electronics Vol GE-16, No 2 pp 112-118 discloses a probe in accordance with the pre-characterising portion of claim 1 but in which the axial extent of the gap between electrode and the probe is approximately one quarter of the diameter of the electrode.

A similar probe is disclosed in GB-717,127, here again the axial extent of the gap is greater than one fifth of the diameter of the electrode.

According to the present invention, there is provided a probe for measuring a characteristic of fluid or solid material or materials and/or for exercising a control in dependence upon the value of said characteristic, said probe comprising an elongated, electrically conductive, probe member which is insulated from and which carries at one end thereof electrode means, the probe member being spaced from the nearest part of the said electrode means by a gap; electrical means which are arranged in operation to cause the electrode means to produce at least one electric and/or magnetic field; and signal-producing means, responsive to the output of the electrical means, for producing a signal functionally related to the value of said characteristic, the electrode means comprises at least one annular or partannular electrode portion whose axial extent is less than its radial extent so that there is an axially extending electrical and/or magnetic field between the electrode portion or that electrode portion closest to the probe member and the probe member characterised in that the axial extent of the said gap is not more than one fifth of the maximum width or diameter of the or each electrode portion.

Since the axial extent of the gap is not more than one fifth of the maximum width or diameter of the said at least one electrode portion, the said electrical and/or magnetic field will not pass through a very great volume of material whatever may be the shape or size of the vessel and consequently the accuracy of the probe will not be substantially affected by the shape or size of the vessel. At the same time, a differential pressure does not need to be established to make the material pass through the device in which it is being measured.

Moreover, since the electrode means comprises at least one annular or part-annular electrode portion whose axial extent is less than its radial extent, a good axially extending electrical and/or magnetic field is in operation established between the or each electrode portion and either the probe member or an axially adjacent electrode portion. This field is such that it penetrates the material or materials whose characteristic is being measured along a very fine axial path so as to ensure a high degree of accuracy.

There may be a plurality of electrode portions which are arranged axially of the probe.

The electrode portions may, for example, be constituted by the turns of at least one helical electrode coil. Alternatively, the electrode portions may be constituted by a plurality of separate axially spaced apart rings.

The electrode portion or portions are preferably mounted on an insulator member, e.g. a hollow insulator member adapted for the flow therethrough of the material or materials whose characteristic is to be measured.

The electrical means may comprise a generator (e.g. a high frequency generator) mounted within the probe member.

There may be a detector means, responsive to the output of the generator, which is mounted within the probe member and is arranged to transmit said signal.

The said signal may be transmitted to an indicator which indicates the said value of the characteristic. The indicator may be located externally of the probe member.

Alternatively or additionally, the said signal may be transmitted to control means which control the supply of a said material or materials in dependence upon the value of the said characteristic.

The electrical means are preferably adapted to generate electrical energy at a frequency in the range of 1MHz to 30,000MHz.

The or each electrode portion may be coated with an electrically insulating layer.

There may be an electrode portion which is mounted at one end of the probe member with an insulator member therebetween. The probe may be provided with a second insulator member at least part of which is disposed on the side of the electrode portion remote from the probe member. Moreover, an electrically conductive shield member may be mounted on the side of the second insulator member which is remote from the probe member, the shield member being electrically connected to the probe member.

The invention also provides a method of measuring a characteristic of fluid or solid material or materials comprising the steps of:

disposing a probe as described above in said material or materials;

operating the electrical means before, during or after said probe is disposed in said material or materials to thereby generate at least one electric and/or magnetic field;

detecting the output of the generator; and

employing the signal to indicate the value of the characteristic.

The probe may be disposed in a first said material which abuts a second said material at an interface, relative movement being effected between the probe and the first said material until a change is noted in the value of the said characteristic, said change indicating the position of the said interface.

The invention is illustrated, merely by way of example, in the accompanying drawings, in which:

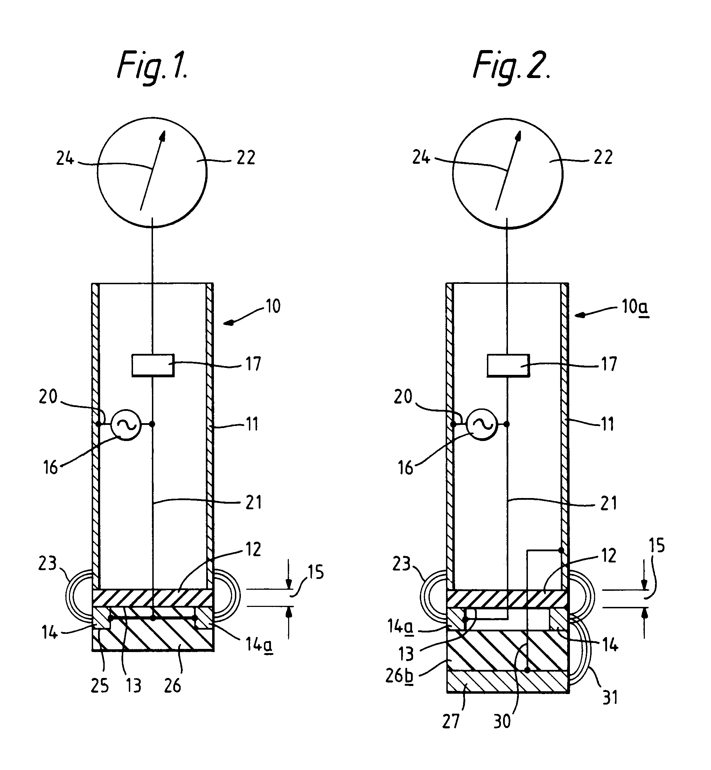

Figures 1-6 respectively illustrate diagrammatically six different embodiments of a probe according to the present invention.

Referring first to Figure 1, a probe 10 according to the present invention comprises a hollow, tubular, electrically conductive probe member 11 one end of which is closed by an insulator member 12. Mounted on the external surface 13 of the insulator member 12, i.e. the surface remote from the probe member 11, is an annular disc-shaped antenna or electrode 14 whose diameter is substantially the same as the external diameter of the probe member 11. The thickness of the insulator member 12, and thus the size of the axial gap 15 between the probe member 11 and the electrode 14, is such that the size of the gap 15 is not more than one fifth, of the external diameter of the electrode 14. The electrode 14 consists of one or more annular or part-annular electrode portions 14a whose axial extents are less than their radial extents. Thus there may be a plurality of angularly spaced apart electrode portions 14a.

The electrode 14 is mounted in an annular groove 25 in an insulator member 26 which is secured to the surface 13 of the insulator member 12 so that part of the insulator member 26 is disposed on the side of the electrode 14 remote from the probe member 11.

Mounted within the probe member 11 is a high frequency electrical generator 16 which is electrically connected to the probe member 11 and the electrode 14 by leads 20, 21 respectively, the lead 21 passing through the insulator member 12. The generator 16 maybe arranged to generate electrical energy at a frequency in the range of 1MHz to 30,000MHz. The current output of the generator 16 is detected by a detector 17 which is mounted within the probe member 11 and is connected to a meter 22 which is disposed externally of the probe member 11, the detector 17 being arranged to transmit a signal representative of the particular characteristic (e.g. impedance) of the material surrounding the probe which is being measured.

An electrical field 23 is thus in operation generated between the probe member 11 and the or each electrode portion 14a and, as will be seen from Figure 1, the axial extent of this field is small by reason of the small axial extent of the gap 15.

In operation, the generator 16 is energised and the probe 10 is gradually introduced into a vessel (not shown) containing, for example, a layer of oil floating on a layer of water. Since there is a difference between the electrical conductivity and dielectric constant of water and oil, the current output of the generator 16 will depend on whether the field or fields 23 is or are wholly within the oil, partly within the oil and partly within the water, or wholly within the water. As this current output varies by reason of the movement of the probe 10, so there will be a variation in the signal transmitted to the meter 22 and therefore a variation in the signal produced by the meter 22 which determines the indication provided by an indicator 24 thereof. Thus the position of the interface (not shown) between the oil and water in the vessel can be determined by gradually introducing the probe 10 further and further into the vessel until the indicator 24 indicates a change in the conductivity and/or the dielectric constant of the portion of the oil/water mixture being examined, such change being indicative of the presence of the interface.

Although the above description refers to a specific liquid/liquid interface, the probe 10 may also be used to determine the position of an interface between a liquid and a granular solid or the interface between two granular solids, or the concentration of one material in a mixture. The probe 10 may also be used to determine the value of any characteristic, e.g. the electrical or magnetic conductivity or capacitance of a gas, liquid or solid. Moreover, instead of (or in addition to) indicating the value of the characteristic (e.g. at the meter 22), the signal produced by the generator 16 may be used (by means not shown) to effect a control, e.g. to adjust process conditions so that the conductivity or other characteristic being examined is maintained substantially constant.

Figures 2 to 6 show probes 10a, 10b, 10c, 10d, 10e which are generally similar to the probe 10 of Figure 1 and which for this reason will not be described in detail, like reference numerals indicating like parts.

In the probe 10a of the Figure 2 construction, the annular electrode 14 is disposed between the insulator member 12 and an insulator member 26b which is spaced by the electrode 14 from the insulator member 12, so that the interior of the electrode 14 is in clear space and so that the insulator member 26b is disposed wholly on the side of the electrode 14 remote from the probe member 11. Moreover, an electrically conductive shield member 27 is mounted on the side of the insulator member 26b which is remote from the probe member 11, the shield member 27 being electrically connected to the probe member 11 by a lead 30 which passes through the insulator members 12, 26b. Thus in the Figure 2 construction, in addition to the electric field 23, there is also at least one electric field 31 between the electrode 14 and the shield member 27 and, in order to limit the axial extent of the or each electric field 31, the thickness of the insulator member 26b, although approximately twice as great as that of the insulator member 12, is not more than one fifth of the diameter of the electrode 14.

The Figure 2 construction can be used to measure an electrical parameter of a portion of a fluid close to the bottom of a tank.

If desired, each of the electrodes 14 of Figures 1 and 2 may be coated with a thin electrically insulating layer (not shown) e.g. of a material such as nylon.

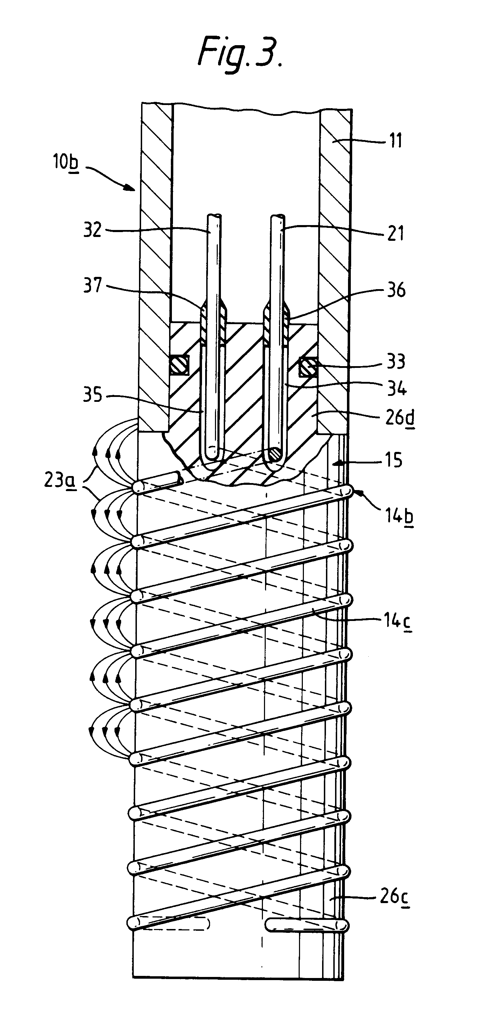

In the probe 10b of the Figure 3 construction, the electrode 14 of Figures 1 and 2 is replaced by an electrode 14b which is constituted by a two start helical coil whose ends are connected respectively to an electrode wire 21 which is connected to the high frequency electrical generator 16 (not shown in Figure 3) and a ground wire 32. The helical electrode coil 14b has a plurality of turns 14c each of which constitutes an annular electrode portion whose axial extent is less than its radial extent. An electrical field 23a is in operation generated between adjacent helical turns 14**c** and between the probe member 11 and the nearest helical turn 14c. The nearest part of the helical electrode coil 14b to the probe member 11 is spaced from the latter by a gap 15 whose axial extent is not more than one fifth of the diameter of the helical electrode coil 14b. The helical electrode coil 14b is wound around a solid cylindrical insulator member 26c which has a reduced diameter end portion 26d which is secured in the distal end of the probe member 11 and is sealed thereto by an O-ring seal 33. The electrode wire 21 and ground wire 32 respectively extend into apertures 34, 35 in the insulator member 26c and are sealed therein by seals 36, 37 respectively. The main part of the insulator member 26c has the same diameter as that of the probe member 11.

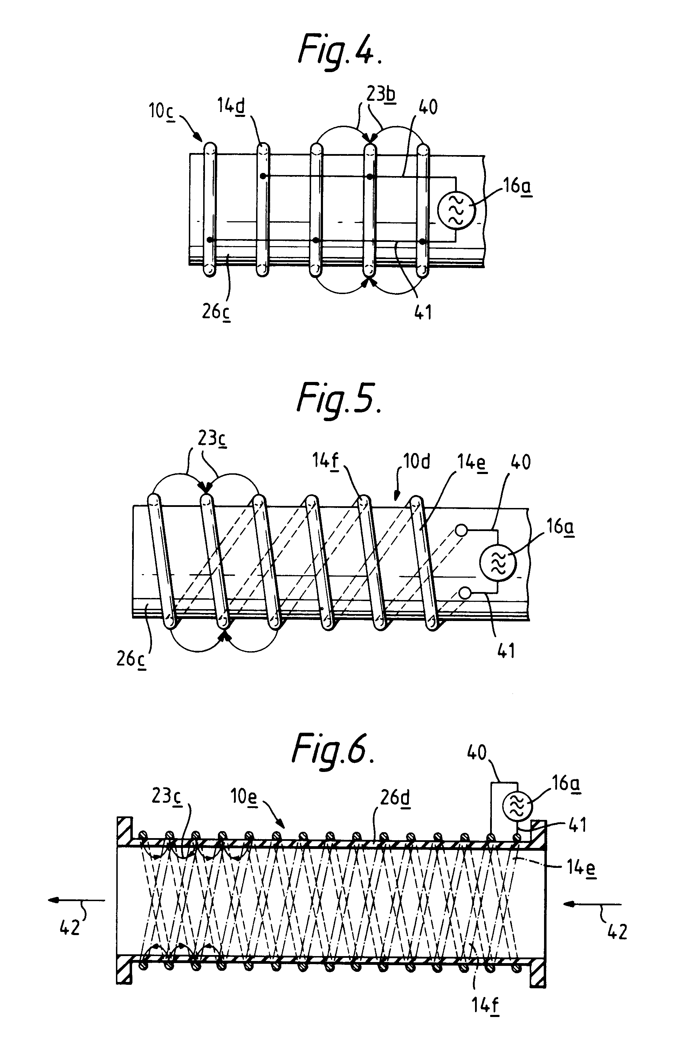

The probe 10c of Figure 4 is generally similar to the probe 10b of Figure 3 except that the helical electrode coil 14b is replaced by a plurality of separate, axially spaced apart electrode rings 14d which are connected across a high frequency generator 16a by leads 40, 41, each lead being connected to alternate electrode rings 14d, whereby electrical fields 23b are in operation generated between each adjacent pair of electrode rings 14d.

The probe 10d of Figure 5 is similar to the probe 10c of Figure 4 except that, instead of a plurality of separate, axially spaced apart electrode rings 14d, first and second helical electrode coils 14e, 14f are wound onto the insulator member 26c so that, in operation, electrical fields 23c are generated between adjacent turns of the first and second helical electrode coils 14e, 14f.

The probe 10e of Figure 6 is similar to the probe 10d of Figure 5 except that the solid cylindrical insulator member 26c is replaced by a tubular insulator member 26d through which may pass a fluid flow, as indicated by arrows 42. The insulator member 26c may be made of polytetrafluoroethylene or other plastics material, or it may be made of glass or ceramic material.

## Claims

1. A probe (10) for measuring a characteristic of fluid or solid material or materials and/or for exercising a control in dependence upon the value of said characteristic, said probe (10) comprising an elongated, electrically conductive, probe member (11) which is insulated from and which carries at one end thereof electrode means (14), the probe member (11) being spaced from the nearest part of the said electrode means (14) by a gap (15); electrical means (16) which are arranged in operation to cause the electrode means (14) to produce at least one electric and/or magnetic field; and signal-producing means (17), responsive to the output of the electrical means (16), for producing a signal functionally related to the value of said characteristic, the electrode means (14) comprises at least one annular or partannular electrode portion (14a) whose axial extent is less than its radial extent so that there is an axially extending electrical and/or magnetic field between the electrode portion (14a) or that electrode portion (14a) closest to the probe member (11) and the probe member (11) characterised in that the axial extent of the said gap (15) is not more than one fifth of the maximum width or diameter of the or each electrode portion (14a).

2. A probe as claimed in claim 1 characterised in that there are a plurality of electrode portions (14c) which are arranged axially of the probe (10b) and in that an axially extending electric and/or magnetic field also exists between each electrode portion and an axially adjacent electrode portion.

3. A probe as claimed in claim 2 characterised in that the annular electrode portions are constituted by the turns of at least one helical electrode coil (14b).

4. A probe as claimed in claim 2 characterised in that the electrode portions are constituted by a plurality of separate axially spaced apart rings.

5. A probe as claimed in any preceding claim characterised in that the electrode portion or portions (14c)is or are mounted on an insulator member (26).

6. A probe as claimed in claim 5 characterised in that the insulator member (26d) is a hollow member adapted for the flow therethrough of the material or materials whose characteristic is to be measured.

7. A probe as claimed in any preceding claim characterised in that the electrical means comprises a generator (16) mounted within the probe member (11).

8. A probe as claimed in claim 7 characterised in that a detector means (17), responsive to the output of the generator (16) is mounted within the probe member (11) and is arranged to transmit said signal.

9. A probe as claimed in any preceding claim characterised in that the or each electrode portion (14a) is coated with an electrically insulating layer.

10. A method of measuring a characteristic of fluid or solid material or materials comprising the steps of:

disposing a probe (10) according to any one of the preceding claims in said material or materials,

operating the electrical means (16) before, during or after said probe is disposed in said material or materials to thereby generate at least one electric and/or magnetic field;

detecting the output of the said electrical means (16), and

employing the signal to indicate the value of the characteristic.

**Patentansprüche**

1. Fühler (10) zur Messung einer Eigenschaft von flüssigem oder festem Material oder Materialien und/oder zur Ausübung einer Prüfung in Abhängigkeit von dem Wert dieser Eigenschaff, umfassend ein längliches, elektrisch leitendes Fühlerbauteil (11), das am einen Ende eine Elektrode (14) trägt, von der es isoliert ist, wobei das Fühlerbauteil (11) durch einen Spalt (15) von dem nähesten Teil der Elektrode (14) getrennt ist; elektrische Mittel (16), die so angeordnet sind, daß sie im Betrieb bewirken, daß die Elektrode (14) mindestens ein elektrisches und/oder magnetisches Feld erzeugt; und auf den Ausgang der elektrischen Mittel (16) reagierende signalerzeugende Mittel (17) zum Erzeugen eines Signals, das als Funktion von dem Wert der Eigenschaff abhängt, wobei die Elektrode (14) mindestens einen ringförmigen oder teilringförmigen Elektrodenabschnitt (14a) aufweist, dessen axiale Ausdehnung geringer ist als seine radiale Ausdehnung, so daß zwischen dem Elektrodenabschnitt (14a) oder dem am nächsten bei dem Fühlerbauteil (11) gelegenen Elektrodenabschnitt (14a) und dem Fühlerbauteil (11) ein sich axial erstreckendes elektrisches und/oder magnetisches Feld entsteht, dadurch gekennzeichnet, daß die axiale Ausdehnung des Spaltes (15) nicht mehr als ein Fünftel der größten Breite oder des Durchmessers des oder jedes Elektrodenabschnitts (14a) beträgt.

2. Fühler nach Anspruch 1, dadurch gekennzeichnet, daß eine Mehrzahl von axial zum Fühler (10b) angeordneten Elektrodenabschnitten (14c) vorhanden sind, und daß auch zwischen jedem Elektrodenabschnitt und einem axial benachbarten Elektrodenabschnitt ein sich axial erstreckendes elektrisches und/oder magnetisches Feld besteht.

3. Fühler nach Anspruch 2, dadurch gekennzeichnet, daß die ringförmigen Elektrodenabschnitte aus den Windungen mindestens einer schraubenförmigen Elektrodenspule (14b) gebildet sind.

4. Fühler nach Anspruch 2, dadurch gekennzeichnet, daß die Elektrodenabschnitte aus einer Mehrzahl von einzelnen, axial voneinander beabstandeten Ringen gebildet sind.

5. Fühler nach einem der vorhergehenden Ansprüche, dadurch gekennzeichnet, daß der oder die Elektrodenabschnitt(e) (14c) auf einem Isolierbauteil (26) montiert ist/sind.

6. Fühler nach Anspruch 5, dadurch gekennzeichnet, daß das Isolierbauteil (26d) ein hohles Bauteil ist, das von dem Material oder den Materialien, von dem/denen die Eigenschaff zu messen ist, durchströmbar ist.

7. Fühler nach einem der vorhergehenden Ansprüche, dadurch gekennzeichnet, daß die elektrischen Mittel (16) einen innerhalb des Fühlerbauteils (11) montierten Generator (16) umfassen.

8. Fühler nach Anspruch 7, dadurch gekennzeichnet, daß ein auf das Ausgangssignal des Generators reagierendes Dedektormittel (17) innerhalb des Fühlerbauteils montiert und so angeordnet ist, daß es das Signal überträgt.

9. Fühler nach einem der vorhergehenden Ansprüche, dadurch gekennzeichnet, daß der oder jeder Elektrodenabschnitt (14a) mit einer elektrisch isolierenden Schicht überzogen ist.

10. Verfahren zum Messen einer Eigenschaff von flüssigem oder festem Material oder Materialien, umfassend die Schritte:

Anbringen eines Fühlers (10) nach einem der vorhergehenden Ansprüche in dem Material oder den Materialien,

Betätigen der elektrischen Mittel (16) vor, während oder nachdem der Fühler in dem Material oder den Materialien angebracht worden ist, um dadurch wenigstens ein elektrisches und/oder magnetisches Feld zu erzeugen,

Bestimmen des Ausgangs der elektrischen Mittel (16) und

Verwenden des Signals, um den Wert der Eigenschaft anzuzeigen.

## Revendications

1. Une sonde (10) pour mesurer une caractéristique d'un matériau ou de matériaux fluide(s) ou solide(s) et/ou pour exercer un contrôle en fonction de la valeur de ladite caractéristique, ladite sonde (10) comprenant un élément de sonde électriquement conducteur de forme allongée (11), qui est isolé de et qui porte à l'une de ses extrémités une électrode (14), l'élément de sonde (11) étant éloigné de la pièce la plus proche de ladite électrode (14) par une distance (15) ; un moyen électrique (16) qui est disposé en fonctionnement pour que l'électrode (14) produise au moins un champ électrique et/ou magnétique ; et des moyens émetteurs de signaux (17) en réponse à la sortie d'un moyen électrique (16), pour produire un signal fonctionnellement lié à la valeur de ladite caractéristique, l'électrode (14) comprenant au moins une partie d'électrode annulaire ou partiellement annulaire (14a) dont la longueur axiale est inférieure à la longueur radiale de sorte qu'il existe un champ électrique et/ou magnétique qui s'étend axialement entre la partie d'électrode (14a) ou la partie d'électrode (14a) qui est la plus proche de l'élément de sonde (11), et l'élément de sonde (11) étant caractérisé en ce que la longueur axiale de ladite distance (15) est inférieure ou égale à un cinquième de la largeur ou du diamètre maximum de la ou de chaque partie d'électrode (14a).

2. Sonde selon la revendication 1, caractérisée en ce qu'elle comprend un ensemble de plusieurs parties d'électrode (14c) qui sont disposées dans l'axe de la sonde (10b) et en ce qu'un champs électrique et/ou magnétique s'étendant axialement existe également entre chaque partie d'électrode et une partie d'électrode axialement adjacente.

3. Sonde selon la revendication 2, caractérisée en ce que les parties de l'électrode annulaires sont constituées par les spires d'au moins une bobine électrode hélicoïdale (14b).

4. Sonde selon la revendication 2, caractérisée en ce que les parties d'électrode sont constituées par un ensemble d'anneaux indépendants espacés axialement.

5. Sonde selon l'une quelconque des revendications précédentes, caractérisée en ce que la ou les portion(s) d'électrode (14c) est ou sont montée(s) sur un élément isolant (26).

6. Sonde selon la revendication 5, caractérisée en ce que l'élément isolant (26d) est un élément creux adapté pour être traversé par le flux du ou des matériau(x) dont la caractéristique doit être mesurée.

7. Sonde selon l'une quelconque des revendications précédentes, caractérisée en ce que le moyen électrique comprend un générateur (16) monté à l'intérieur de l'élément de sonde (11).

8. Sonde selon la revendication 7, caractérisée en ce qu'un moyen détecteur (17) est monté à l'intérieur de l'élément de sonde (11) et est disposé pour transmettre ledit signal en fonction de la sortie du générateur (16).

9. Sonde selon l'une quelconque des revendications précédentes, caractérisée en ce que la ou chaque partie d'électrode (14a) est revêtue d'une couche électriquement isolante.

10. Méthode de mesure d'une caractéristique d'un ou de matériau(x) fluide(s) ou solide(s), comprenant les étapes suivantes :
    - disposer une sonde (10) selon l'une quelconque des revendications précédentes dans ledit ou lesdits matériau(x) ;
    - faire fonctionner le moyen électrique (16) avant, pendant et après l'installation de ladite sonde dans le ou les matériau(x) afin de générer ainsi au moins un champ électrique et/ou magnétique ;
    - détecter la sortie dudit moyen électrique (16), et
    - employer le signal pour indiquer la valeur de la caractéristique.

# Fig.1.

# Fig.2.

# Fig.3.

## Fig.4.

## Fig.5.

## Fig.6.